# FASCICULE DE BREVET EUROPEEN

(11) **EP 2 747 126 B1**
(45) Date de publication et mention de la délivrance du brevet: **15.04.2015**
(21) Numéro de dépôt: 13197601.1
(22) Date de dépôt: 17.12.2013
(51) Int. Cl.: H01L 21/02, C23C 16/44

(54) **Procédé de recyclage d'un support de substrat**
Recyclingverfahren einer Substratunterlage
Method for recycling a substrate holder

(30) Priorité: 21.12.2012 FR 1262737
(43) Date de publication de la demande: 25.06.2014
(73) Titulaire: COMMISSARIAT A L'ENERGIE ATOMIQUE ET AUX ENERGIES ALTERNATIVES, 75015 Paris (FR)
(72) Inventeur: Fournel, Frank, 38190 VILLARD-BONNOT (FR); Moriceau, Hubert, 38120 SAINT-EGREVE (FR); Zussy, Marc, 38120 SAINT EGREVE (FR)
(74) Mandataire: Delorme, Nicolas

(56) Documents cités:
- EP-A1- 2 048 697
- EP-A1- 2 339 617

## Description

La présente invention concerne un procédé de recyclage d'un support de substrat, notamment utilisé dans le domaine de la microélectronique, le support de substrat étant adapté à une manipulation d'un substrat pour au moins une étape de dépôt d'une couche d'un matériau sur le substrat.

Les supports de substrat, communément appelés 'holders' selon la terminologie anglo-saxonne, sont généralement utilisés pour réaliser des opérations technologiques, dans le domaine de la microélectronique notamment, à partir de substrats dont le diamètre est inférieur au diamètre des substrats standards (c'est à dire aux substrats dont les dimensions permettent la manipulation et la réalisation d'opérations technologiques dans des équipements standards actuellement disponibles). Ainsi ces substrats de dimensions non standards peuvent tout de même être traités par des dispositifs classiques, conçus pour réaliser des opérations technologiques sur des substrats standards. Par exemple, avec un support de substrat 200/300, il est possible de réaliser le dépôt d'une couche d'un matériau diélectrique sur des substrats de silicium de 200 mm de diamètre tout en utilisant un dispositif de dépôt conçu pour des substrats de 300 mm de diamètre.

Or, les supports de substrat utilisés dans des dispositifs de dépôt de couche présentent une durée de vie limitée. En effet, au-delà d'une épaisseur seuil de couches déposées cumulées sur le support, la quantité de matériau accumulé est susceptible de provoquer des modifications des conditions de dépôt standard ou des propriétés des dépôts ultérieurs. Par exemple, pour un support de substrat en silicium, lorsque l'empilement de couches de SiO₂ déposées sur le support présente une épaisseur au-delà d'une épaisseur seuil, l'empilement de SiO₂ pèle. Ceci induit la formation de particules polluant le dépôt d'une nouvelle couche de SiO₂ sur un substrat. La présence d'une grande quantité de SiO₂ sur le support peut également induire une capacité pouvant modifier les conditions de formation du plasma nécessaire au dépôt d'une nouvelle couche de Si02. Il est donc nécessaire de retirer de l'empilement de couches formé sur le support de substrat afin de recycler ce support et de pouvoir le réutiliser dans de nouvelles étapes de dépôt.

A cet effet, il est possible d'effectuer une gravure chimique de l'empilement de couches déposées sur le support. Par exemple, dans le cas d'un empilement de couches de Si02, une solution d'acide fluorhydrique (HF) peut être efficacement utilisée. Cependant, certains matériaux déposés ne sont pas attaqués par les solutions chimiques de gravure existantes à ce jour, ou leur vitesse de gravure est très lente, ce qui impose un traitement très long de recyclage. De plus, lorsque les dépôts successifs forment des empilements de matériaux divers, il est difficile de trouver une solution chimique unique capable de retirer l'ensemble des couches déposées. L'enchainement de plusieurs traitements dans plusieurs solutions chimiques est trop long pour être envisageable.

Par ailleurs, il est aussi possible d'utiliser un rodage mécanique pour retirer l'empilement de couches déposées sur le support. Cependant, certains supports de substrat peuvent présenter une géométrie rendant impossible l'utilisation du rodage. C'est notamment le cas de supports de substrat dont la face d'accueil présente une couronne de matière périphérique. Dans ce cas, il est difficile d'effectuer un rodage mécanique sans modifier les dimensions de la couronne, ni l'épaisseur du support de substrat.

Le document EP-A-2 048 697 décrit un procédé de recyclage d'un support de substrat comprenant des étapes de recuit thermique , retrait d'oxyde et polissage.

La présente invention vise à pallier l'un ou plusieurs de ces inconvénients. A cet effet, la présente invention propose un procédé de recyclage d'un support de substrat dont une face, dite face d'accueil, est adaptée à la réception d'un substrat conçu pour au moins une étape de dépôt d'une couche d'un matériau sur ledit substrat, l'étape de dépôt conduisant également au dépôt d'une couche d'un matériau sur ledit support, le procédé comprenant les étapes consistant à :
a) Implanter des espèces ioniques à travers la face d'accueil du support de substrat de sorte à former au moins un plan de fragilisation enterré délimitant un film mince sous la face d'accueil du support de substrat,
b) Exfolier le film mince du support de substrat de sorte à morceler le film mince, et
c) Retirer un empilement comportant au moins une couche d'un matériau déposé sur le film mince résultant de ladite au moins une étape de dépôt de la couche d'un matériau sur le substrat.

Par l'expression 'film mince', on entend dans le présent document un film mince présent sous la face d'accueil du support de substrat, le film mince étant continu ou discontinu notamment dans une direction suivant sensiblement l'épaisseur du support de substrat.

Par l'expression 'plan de fragilisation enterré', on entend une zone fragilisée par l'implantation, de faible épaisseur, située autour de la profondeur d'implantation.

Ainsi, la présente invention permet de faciliter le retrait du matériau déposé sur la face d'accueil du support qui était non recouverte par le substrat au moment d'une étape de dépôt d'une couche. Lorsque plusieurs étapes de dépôt sont réalisées, le matériau retiré correspond à l'empilement de plusieurs couches sur le support. D'une part, le procédé de la présente invention permet de s'affranchir des contraintes liées à la nature des matériaux déposés ainsi que des contraintes liées à la géométrie du support. Ainsi, peu importe la nature et le nombre de couches déposées, puisqu'on agit directement par implantation et exfoliation du support. D'autre part, le procédé de l'invention est applicable sur toute géométrie de support. En effet, la profondeur d'implantation des espèces ioniques est constante pour un support constitué d'un même matériau. Ainsi, le film mince formé par implantation reproduit le profil de la face d'accueil du support. L'exfoliation du film mince permet alors de retirer la même épaisseur de matériau en tout point de la face d'accueil du support. Le support conserve ainsi sa géométrie initiale. En conséquence, le support de substrat est efficacement recyclé et peut être utilisé pour de nouveaux dépôts de couche de qualité sur des substrats. Il est entendu dans le présent document que les conditions d'implantation d'espèces ioniques sont adaptées de sorte que l'utilisation du support de substrat implanté dans la au moins une étape de dépôt ne provoque pas l'exfoliation du film mince.

Il est précisé que par l'expression 'exfolier le film mince', on entend dans le présent document le fait de morceler le film mince en différents fragments (ou morceaux, portions), qui sont alors désolidarisées du négatif, partie du support de substrat sous-jacent. Cette étape d'exfoliation contribue également à fragmenter l'empilement de couche(s) recouvrant au moins en partie le film mince de sorte que le retrait de l'empilement de la surface du négatif est facilité. A l'issue de l'exfoliation, ces fragments de film mince et de l'empilement peuvent demeurer à la surface du négatif ou avoir été projetés. Dans ce cas, ils peuvent alors former différents amas de fragments répartis notamment sur la surface du négatif.

Avantageusement, le support de substrat est formé d'un matériau cristallin et de préférence monocristallin, tel que du silicium monocristallin.

De préférence, le procédé comporte, après l'étape d'implantation a), une étape de formation d'une couche additionnelle sur le film mince du support de substrat et l'étape de retrait c) comporte une étape de pelage de ladite couche additionnelle. Par le terme 'pelage', on entend dans le présent document, le fait de retirer une couche en un seul tenant ou sous la forme de plusieurs lambeaux. Par l'expression 'formation d'une couche additionnelle' on entend dans le présent document le dépôt d'une couche additionnelle et la réticulation du matériau de la couche si nécessaire.

Ainsi, la surface des fragments de matériaux de la surface du négatif du support adhère à la couche additionnelle si bien que le pelage de chaque lambeau de couche additionnelle est susceptible de retirer plusieurs fragments. Le retrait des fragments et le nettoyage de la surface du négatif est ainsi facilité.

Selon une disposition, la couche additionnelle est réalisée en un matériau de polymère, notamment un polymère vitreux tel que du BCB (BenzoCycloButène), et par exemple du DVS-bis-BCB (DiVinylSyloxane-bis-benzoCycloButène). En effet, la nature de la couche additionnelle est choisie de sorte à permettre l'éventuelle montée en température du traitement d'exfoliation selon l'étape b) du procédé. Le BCB est un matériau de choix car il peut être réticulé à des températures jusqu'à 320°C et monté pendant plusieurs heures à des températures de 400°C sans dégradation notable. Dans ce cas, il est possible d'implanter de faibles doses d'espèces ioniques pour élever les budgets thermiques d'exfoliation de sorte à permettre le dépôt, notamment de BCB, à des températures élevées, par exemple de 300°C sans entrainer l'exfoliation, tout en réduisant le coût et la durée de l'étape d'implantation. Le polymère BCB est également avantageux en ce qu'il présente un coefficient de dilatation thermique (connu sous l'acronyme anglais CTE pour coefficient of thermal expansion) plus élevé que celui d'un support de substrat de silicium à température ambiante, respectivement de l'ordre de 40 ppm et de l'ordre de 2.5 ppm. Lors des différents traitements thermiques appliqués à la structure, cette différence de CTE engendre des contraintes permettant de favoriser le pelage et le retrait.

Par exemple, après le dépôt de la couche additionnelle en BCB et le traitement thermique de polymérisation de la résine, par exemple à 300°C, les contraintes liées aux différences de CTE entre les matériaux en revenant à température ambiante permettent de faciliter le retrait de l'empilement et du polymère sous forme de lambeaux. Lorsque la couche additionnelle de BCB présente par exemple une épaisseur de plus de 100 micromètres, le retrait de l'empilement et de la couche a lieu brusquement au cours de la diminution en température.

Typiquement, la couche additionnelle présente une épaisseur supérieure à 10µm. Cette épaisseur de couche additionnelle est en effet favorable au retrait de l'empilement après l'exfoliation.

Selon une possibilité, l'épaisseur de la couche additionnelle peut éventuellement être obtenue par un dépôt effectué en deux temps. Dans ce cas, une première partie de couche est déposée avant l'étape a) d'implantation et une autre partie de couche est déposée après l'étape a) d'implantation. L'épaisseur de la première partie de couche additionnelle déposée avant l'étape d'implantation présente avantageusement une épaisseur inférieure au micron de sorte à permettre aux espèces implantées de pénétrer suffisamment dans le support de substrat, sous les couches déposées.

Il est entendu dans le présent document que la formation d'une couche additionnelle sur le film mince signifie que la couche peut être déposée directement sur et au contact du film mince ou, le cas échéant, sur l'empilement d'au moins une couche recouvrant au moins en partie le film mince.

Selon une disposition, l'étape de formation de la couche additionnelle est effectuée après l'étape d'exfoliation b). De la sorte, les fragments déjà formés présentent ensemble une surface disponible pour adhérer à la couche additionnelle qui est plus importante.

Dans cette configuration, l'étape de pelage de la couche additionnelle peut être avantageusement effectuée aussitôt après l'étape de formation de la couche additionnelle. Ainsi, le retrait des différentes portions de film mince et de l'empilement est facilité.

Selon une alternative, l'étape de formation de la couche additionnelle est effectuée avant l'étape d'exfoliation b). La présence de la couche additionnelle permet d'éviter une contamination particulaire (avec les fragments formés) de l'environnement où a lieu l'exfoliation, tel qu'un four. Dans certains cas, la dispersion de certains matériaux sous forme pulvérulente est même à éviter pour des raisons de sécurité, par exemple avec des matériaux III-V ou II-V comme l'AsGa ou l'InP.

Selon une réalisation possible, l'étape de retrait c) comporte une étape de nettoyage de la surface du négatif du support de substrat par jet d'eau sous pression. Par le terme 'négatif du support de substrat', on entend dans le présent document le résidu du support de substrat sous jacent au film mince, délimité par le plan de fragilisation enterré du coté opposé au film mince et qui est désolidarisé du film mince après l'exfoliation. Ainsi, ce nettoyage permet de retirer efficacement les fragments de l'empilement et du film mince pour finaliser le recyclage du négatif support de substrat. Il est possible après cette étape de reconditionner la surface du négatif support de substrat pour la rendre compatible avec une nouvelle utilisation. A cet effet, il est possible d'effectuer des traitements chimiques pour rendre la face d'accueil hydrophobe par exemple, d'effectuer des recuits thermiques pour la lisser ou au contraire de dégrader sa rugosité pour dégrader son adhérence. Il est aussi possible de réaliser une oxydation thermique ou un dépôt d'autres matériaux spécifiques pour rendre compatible le support avec une réutilisation.

L'étape de nettoyage par jet d'eau sous pression peut être effectuée après l'étape de pelage d'une couche additionnelle. Dans ce cas, le jet d'eau permet de compléter le nettoyage du négatif du support de substrat pour une future utilisation.

Selon une possibilité, l'étape d'exfoliation b) du film mince comprend une étape d'application d'un traitement thermique d'exfoliation. En effet, le traitement thermique permet la croissance du nombre et de la taille des cavités formées à la suite de l'implantation des espèces ioniques, les cavités définissant le plan de fragilisation enterré. Le traitement thermique d'exfoliation consiste alors en l'application d'un budget thermique dont la température et la durée sont adaptées pour obtenir l'exfoliation au niveau du plan de fragilisation enterré. Ce budget thermique est exécuté à une température fixe ou variable selon des durées déterminées. Cette étape de traitement thermique d'exfoliation peut être assistée par un effort mécanique.

Selon une variante, tout ou une partie du traitement thermique d'exfoliation est effectué avant la formation d'une couche additionnelle. Ceci permet de ne pas endommager le matériau de la couche additionnelle pouvant être sensible à la température appliquée lors de ce traitement. Dans ce cas, souvent lié à l'utilisation d'un polymère, le traitement thermique peut être effectué avant le dépôt de la couche additionnelle en polymère et l'exfoliation peut être obtenue par l'application d'un effort mécanique complémentaire et/ou l'application d'un budget thermique complémentaire à une température compatible avec le polymère.

Selon une disposition, l'étape d'implantation a) conduit à la formation de cavités définissant le film mince et le procédé comprend, après l'étape d'implantation a) et avant l'étape d'exfoliation b), une étape de prétraitement thermique adaptée à la croissance du nombre et de la taille de cavités. Cette étape permet de préparer l'étape d'exfoliation par application du prétraitement thermique dont le budget thermique correspond à une fraction du budget thermique conduisant à l'exfoliation. Bien entendu, ce prétraitement thermique est adapté de sorte que le budget thermique et/ou les contraintes mécaniques apportées par la au moins une étape de dépôt d'une couche d'un matériau sur un substrat ne provoque pas l'étape d'exfoliation.

De préférence, l'étape d'exfoliation b) du film mince comprend une étape comportant un dépôt d'une couche superficielle sur le film mince et sur l'empilement d'au moins la couche d'un matériau déposée sur le film mince. Selon la nature et l'épaisseur du matériau de la couche superficielle déposée, cette dernière augmente la raideur de l'ensemble des couches situées du coté du film mince par rapport au plan de fragilisation de sorte que l'étape d'exfoliation conduit à un morcèlement en des fragments de plus grandes tailles. Il est entendu dans le présent document que la couche superficielle ne permet pas d'apporter l'effet raidisseur nécessaire à l'obtention d'un détachement d'un film mince continu.

De façon avantageuse, le matériau de la couche superficielle présente un coefficient de dilatation thermique (ou CTE selon l'acronyme anglais « coefficient of thermal expansion ») différent du CTE du matériau du support de substrat. Ainsi, la contraction ou la dilatation du matériau du support de substrat est différente de celle du matériau de la couche superficielle lors de changements de température. Le support de substrat présentant une épaisseur plus importante que celle de la couche superficielle, le support impose la contraction ou dilatation à la couche superficielle, générant des contraintes dans cette dernière. Ces contraintes provoquent l'exaltation des forces de pelage présentes en périphérie de l'empilement déposé, ce qui favorise l'exfoliation. De ce fait, il est alors possible de diminuer la dose d'espèces ioniques implantées de sorte à diminuer la durée d'implantation, le coût du recyclage du support ou à diminuer le budget thermique avant exfoliation. En effet à dose plus faible, le budget thermique pour obtenir l'exfoliation est généralement augmenté.

De façon préférée, la couche superficielle présente une contrainte intrinsèque. Cette contrainte, liée au mode de dépôt de la couche, peut alors être utilisée pour participer aux efforts de détachement de l'empilement par pelage du support de substrat.

Selon une possibilité, le procédé comprend une étape de formation d'une couche additionnelle et d'une couche superficielle sur le film mince de sorte à renforcer l'effet raidisseur et à augmenter l'effet des contraintes apportées par les différences de coefficient de dilatation thermique des matériaux.

Selon une disposition, la face d'accueil du support de substrat comporte une région principale plane permettant de recevoir un substrat et une région périphérique comprenant une surépaisseur de matière permettant de maintenir le substrat pour le dépôt d'une couche d'un matériau, et l'étape d'implantation a) comprend une implantation d'espèces ioniques à travers la région périphérique de la face d'accueil de sorte que le plan de fragilisation enterré délimite un film mince sous la région périphérique.

Ainsi, le plan de fragilisation et le film mince formés par cette étape a) sont situés uniquement sous la région périphérique de la face d'accueil. Ceci est avantageux en ce que la couche d'un matériau n'est pas déposée sur région principale plane de la face d'accueil recevant le substrat. Il est donc inutile d'exfolier un film mince au niveau de cette région principale plane. Grâce à cette disposition, l'état de la région principale plane du support n'est pas modifié par l'implantation, ce qui permet de minimiser l'étendue de la face d'accueil à traiter.

Il est entendu dans le présent document que la région principale plane et la région périphérique peuvent être constituées ou non d'un même matériau.

La région périphérique comprenant une surépaisseur de matière peut être formée par des plots espacés de matière ou une couronne continue ou discontinue de matière entourant la région principale plane de sorte à encercler le substrat pour un bon maintien pendant sa manipulation en dehors et dans le dispositif de dépôt de couche.

Selon une variante, l'étape d'implantation a) est réalisée sous la région principale plane et sous la région périphérique conduisant à la formation d'un premier plan de fragilisation enterré sous la région principale plane et la formation d'un deuxième plan de fragilisation enterré sous la région périphérique, le cumul du premier plan de fragilisation enterré et du deuxième plan de fragilisation enterré délimitant le film mince.

Dans le cas d'un matériau unique pour la région principale plane et la région périphérique, la profondeur d'implantation d'espèces ioniques est constante sous la face d'accueil du support, le plan de fragilisation enterré obtenu présente alors une topologie identique à celle de la face d'accueil du support. Ainsi l'exfoliation a lieu sur la totalité de la face d'accueil du support de substrat en reproduisant la topologie de la face d'accueil.

Selon une disposition, le procédé de recyclage comprend avant l'étape b), les étapes consistant à i) déposer le substrat sur la face d'accueil du support de substrat, ii) déposer la couche d'un matériau sur le substrat et sur ledit support de substrat, iii) retirer le substrat de la face d'accueil et l'étape c) comprenant le retrait de l'empilement comportant au moins la couche d'un matériau déposé sur le support de substrat.

De préférence, le procédé de recyclage comprend la répétition au moins une fois des étapes i) à iii) avant la réalisation de l'étape b) d'exfoliation.

Avantageusement, le procédé comprend, avant l'étape d'exfoliation b), plusieurs étapes successives de dépôt d'une couche d'au moins un matériau de manière à former un empilement de plusieurs couches successives d'au moins un matériau sur le film mince. De la sorte, le recyclage est effectué après plusieurs utilisations du support de substrat de sorte à optimiser les rendements et les coûts de recyclage.

Selon une disposition, l'étape d'implantation a) est réalisée après au moins une étape de dépôt d'une couche d'un matériau sur le substrat. L'épaisseur de matériau située au-dessus du plan de fragilisation enterré est alors augmentée ce qui favorise la formation de fragments de plus grandes dimensions lors de l'étape d'exfoliation b). Ceci permet de limiter l'énergie d'implantation des espèces ioniques pour former le plan de fragilisation enterré au sein du support de substrat.

Selon une alternative, l'étape d'implantation a) est réalisée avant une étape de dépôt d'une couche d'un matériau sur le substrat.

Selon une possibilité, l'étape d'exfoliation b) est réalisée lorsque l'épaisseur de l'empilement d'au moins une couche d'un matériau déposé sur le film mince est de préférence inférieure à 50 micromètres, voire inférieure à 20 micromètres, et par exemple comprise entre 1 et 7 micromètres. L'utilisation du support de substrat est ainsi optimisée de sorte que le recyclage n'intervient que lorsque l'empilement d'au moins un matériau déposé sur le support dépasse une épaisseur seuil altérant la qualité du dépôt de la couche.

Selon un exemple de réalisation possible, le support de substrat comprend une plaque de silicium de 300 mm de diamètre comportant une couronne présentant une épaisseur supérieure à 725 micromètres et une largeur comprise entre 5 mm et 5 cm, le support de substrat étant adapté pour au moins une manipulation d'un substrat de silicium présentant un diamètre de 200 mm et pour au moins le dépôt d'une couche d'un matériau en dioxyde de titane d'une épaisseur d'environ 1.5µm, l'étape a) comprenant une implantation d'hydrogène avec une énergie comprise entre 1 et 300keV, de préférence 250keV, et une dose comprise entre 1.10¹⁵ et 1.10¹⁷ at/cm², l'étape d'exfoliation b) comprenant l'application d'un traitement thermique à une température comprise entre 200°C et 500°C sur une durée comprise entre quelques minutes à quelques heures et l'étape de retrait c) de l'empilement comprenant un étape de formation puis une étape de pelage d'une couche additionnelle de BCB déposée sur le film mince.

D'autres aspects, buts et avantages de la présente invention apparaîtront mieux à la lecture de la description suivante d'un mode de réalisation de celle-ci, donné à titre d'exemple non limitatif et fait en référence aux dessins annexés. Les figures ne respectent pas nécessairement l'échelle de tous les éléments représentés de sorte à améliorer leur lisibilité. Les traits pointillés symbolisent un plan de fragilisation enterré. Dans la suite de la description, par souci de simplification, des éléments identiques, similaires ou équivalents des différentes formes de réalisation portent les mêmes références numériques.
- Les figures 1 à 6 représentent un mode de réalisation du procédé selon l'invention.
- La figure 7 illustre une variante de réalisation.
- Les figures 8 à 13 représentent une variante du mode de réalisation du procédé illustré aux figures 1 à 6.
- La figure 14 illustre une autre variante de réalisation du procédé selon l'invention.
- Les figures 15 à 19 représentent encore une autre variante de réalisation du procédé selon l'invention.

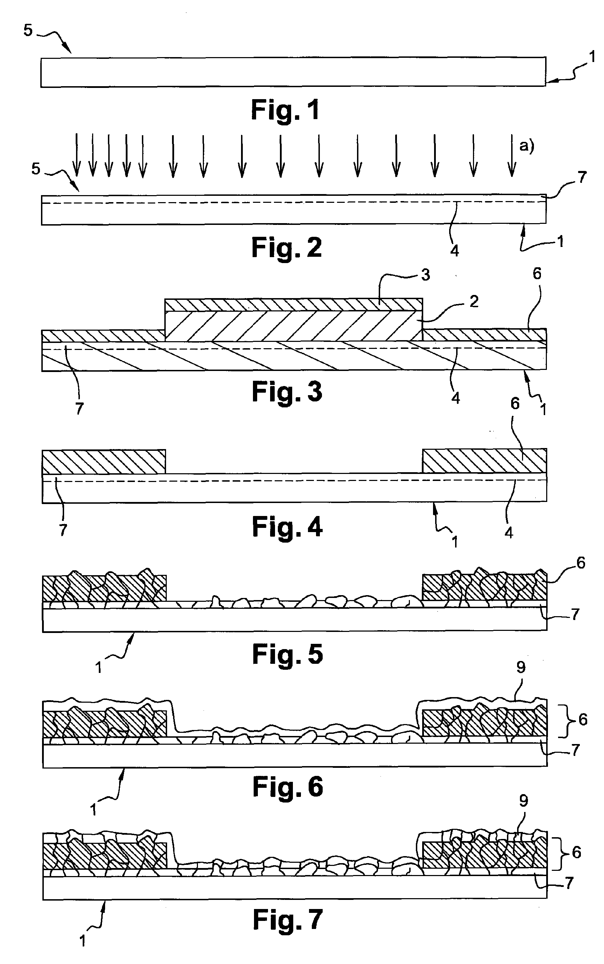

La figure 1 illustre un support 1 de substrat formé d'une plaque de silicium présentant une face d'accueil 5 plane de 300 mm de diamètre et une résistivité d'environ 10 ohm.cm. Cette plaque est notamment adaptée à la réception, au maintien et à la manipulation d'un substrat 2, par exemple de silicium de 200 mm de diamètre sur lequel une couche d'un matériau 3 doit être déposée.

La figure 2 représente une étape a) du procédé consistant à implanter des espèces ioniques dans le support 1, tels que des ions hydrogène, avec une comprise entre 1 et 300keV, par exemple 180keV, et une dose comprise entre 1.10¹⁵ et 1.10¹⁷ at/cm², par exemple 5.10¹⁶ at/cm². Cette implantation conduit à former un plan de fragilisation enterré 4 au sein du support 1 de façon sensiblement parallèle à la face d'accueil 5 et délimitant un film mince 7.

La figure 3 illustre une étape de dépôt à 200°C d'une couche de dioxyde de titane TiO₂ sur la surface d'un substrat 2 maintenu sur le support 1 de substrat. Le support 1 de substrat présentant un diamètre supérieur à celui du substrat 2, la couche 3 de dioxyde de titane est également déposée sur le support 1, ce qui initie la formation d'un empilement 6 sur le support 1.

La figure 4 illustre le support 1 de substrat ayant été utilisé au préalable pour effectuer plusieurs dépôts successifs d'une couche 3 de TiO₂ sur un substrat 2 (le dernier substrat sur lequel un dépôt d'une couche 3 a été effectué ayant été retiré du support). L'empilement 6 de couches de matériau déposé sur le support 1 résulte ainsi des dépôts successifs de couches 3 effectués chacun sur un substrat 2 de silicium. Lorsque l'épaisseur de l'empilement 6 atteint une valeur seuil, ici de 5 micromètres environ, une étape d'exfoliation b) du film mince 7 est effectuée comme illustré à la figure 5. La valeur seuil de l'épaisseur de l'empilement 6 au-delà de laquelle l'exfoliation est effectuée dépend de la nature du matériau déposé, du budget thermique global utilisé pour réaliser l'empilement et est déterminé par le moment à partir duquel le dépôt d'une nouvelle couche 3 est perturbé, par variation du procédé de dépôt (variation de capacitance en plasma radiofréquence...) ou par détachement de particules à partir de l'empilement 6.

Comme illustré à la figure 5, l'étape d'exfoliation b) conduit au morcèlement du film mince 7 et de l'empilement 6, les fragments issus de l'exfoliation demeurant en surface du négatif 8 du support 1 ou étant amassés en différents tas à sa surface. L'étape d'exfoliation b) peut être obtenue par application d'un traitement thermique d'exfoliation sur le support 1 de substrat, tel qu'illustré à la figure 4. Ce traitement thermique d'exfoliation réalisé environ à 500°C pendant 2 heures apporte le budget thermique permettant la croissance du nombre et/ou de la dimension des cavités formées grâce à l'implantation. Ceci provoque la fracture du matériau au niveau du plan de fragilisation enterré 4 et l'exfoliation du film mince 7 et de l'empilement 6 le recouvrant au moins en partie (figure 5).

Il est entendu dans le présent document que les conditions d'implantation, le budget thermique appliqué et l'épaisseur des matériaux présents au-dessus du plan de fragilisation enterré 4 ne sont pas adaptés au détachement d'un film mince 7 entier et continu de matériau mais à l'obtention d'un morcellement du film mince 7 en plusieurs fragments.

La figure 6 illustre une étape de retrait c) de l'empilement 6 qui a été morcelé avec le film mince 7.

A cet effet, une couche additionnelle 9 de polymère est déposée, par exemple par une technique de dépôt à la tournette (connue sous la terminologie anglo-saxonne 'spin coating') ou par pulvérisation (connue sous la terminologie anglo-saxonne 'spray'), sur la surface des fragments (encore attenant au support 1 de substrat) puis il est procédé au pelage, par exemple avec un outil de préhension et de décollement adapté, de la couche additionnelle 9. Les fragments adhérent à la couche additionnelle 9 et sont alors aisément retirés lors du pelage. Lorsque la couche additionnelle 9 de polymère est un film de BCB (par exemple XU35075 de Dow), il est épandu par spin coating entre 500 et 1000 rpm (acronyme anglais de Round Per Minute) avec une épaisseur de l'ordre de 40 mciromètres. La résine obtenue est polymérisée à 250°C pendant au moins 1 h.

Selon une variante illustrée en figure 7, l'étape de formation de la couche additionnelle 9 a lieu avant l'étape d'exfoliation b) et l'étape de retrait des fragments de l'empilement et du polymère est effectuée par pelage après l'exfoliation. Dans ce cas, lorsque le polymère est de type BCB, la température d'exfoliation est réduite à 400°C pour ne pas endommager le polymère et la durée est allongée à 5h.

Le négatif 8 du support 1 de substrat est alors libéré des fragments de l'exfoliation, sa surface présente une topologie voisine à celle de la face d'accueil 5 du support 1 initial. Le négatif 8 peut à nouveau être utilisé pour des étapes de dépôt d'une couche 3 sur un substrat 2. De même, il peut être recyclé après un certains nombre d'étapes de dépôt d'une couche 3, dans les mêmes conditions que celles précédemment décrites.

Selon une possibilité, la surface du négatif 8 du support 1 de substrat est ensuite nettoyée par jet d'eau sous pression.

Selon une autre alternative non illustrée, l'étape de retrait c) de l'empilement 6 n'est obtenu que par l'utilisation d'un jet d'eau sous pression sur le support 1 illustré à la figure 5, sans effectuer de dépôt ni de pelage d'une couche additionnelle 9 au préalable.

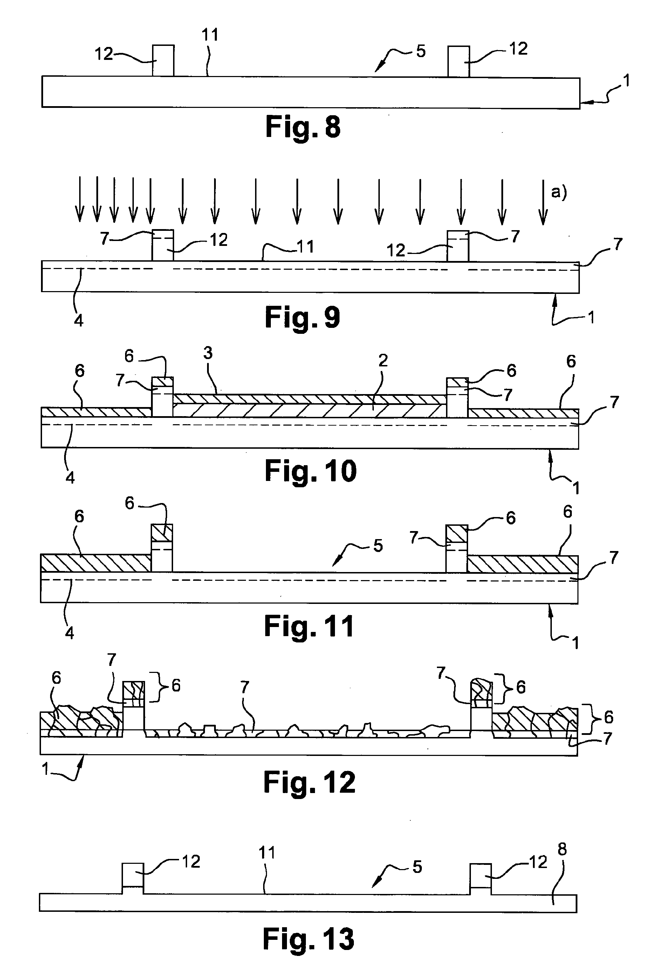

La figure 8 illustre un support 1 de substrat en silicium de 300 mm de diamètre par exemple dont la face d'accueil 5 comporte une région principale plane 11 et une région périphérique 12 rapportée présentant la forme d'une couronne de matière, permettant de recevoir et de maintenir un substrat 2 de silicium ou de germanium présentant un diamètre de 200 mm et d'épaisseur 450 micromètres. Dans cet exemple, la couronne 12 présente une épaisseur d'environ 720 micromètres et une largeur comprise entre 5 mm et 5 cm.

La figure 9 illustre l'étape d'implantation d'ions hydrogène, avec une énergie d'environ 190keV et une dose d'environ 7.10¹⁶ at/cm² de sorte à former un premier plan de fragilisation enterré sous la région principale plane 11 et un deuxième plan de fragilisation enterré annulaire sous la région de couronne 12. Comme illustré à la figure 9, ces deux plans de fragilisation forment un film mince 7 discontinu mais s'étendant sous la totalité de la face d'accueil 5 du support 1. Dans le cas où la région de la couronne 12 et la région principale 11 sont en un même matériau, par exemple du silicium, les profondeurs de réalisation des deux plans de fragilisation sont identiques.

Selon une possibilité non illustrée, l'implantation est réalisée uniquement à travers la région périphérique 12 comprenant la couronne de sorte à n'exfolier qu'une portion de la face d'accueil 5 du support 1 de substrat.

La figure 10 illustre une étape de dépôt d'une couche 3 de SiO₂ (par exemple par PECVD), de nickel (par exemple par PVD) ou de TiO₂ sur le substrat 2. Le support 1 de substrat présentant un diamètre supérieur à celui du substrat 2, ce dépôt conduit également à la formation d'une couche 3 de matériau sur le support 1.

La figure 11 illustre l'empilement 6 formé par la succession de couches déposées sur le support 1, résultant de l'utilisation du support 1 pour le maintien successif de plusieurs substrats 2 sur lesquels un dépôt d'une couche 3 a été effectué.

Comme illustré à la figure 12, une fois la valeur seuil de l'épaisseur de l'empilement 6 au-delà de laquelle un nouveau dépôt de couche 3 n'est plus optimal, telle que 5 micromètres, il est procédé à l'application d'un traitement thermique d'environ 2 heures à 500°C de sorte à provoquer l'exfoliation du film mince 7.

Comme illustré à la figure 13 selon une possibilité de réalisation, une étape de retrait effectué par pelage d'une couche additionnelle 9 formée avant l'étape exfoliation (non illustrée sur les figures) permet de nettoyer toute la surface du négatif 8 du support 1. Dans le cas d'une couche additionnelle de polymère, par exemple de BCB, la température d'exfoliation est réduite, par exemple à 400°C.

Le négatif 8 présente une région principale plane 11 et une région périphérique 12 en couronne formées de matière similaires respectivement aux régions 11,12 du support 1 de substrat avant utilisation. En conséquence, le négatif 8 peut être utilisé comme nouveau support 1 de substrat pour de nouveaux dépôts de couche 3 de la même façon que précédemment décrit. Selon une possibilité non décrite, une fois l'épaisseur seuil de l'empilement 6 de couches atteint sur le négatif 8, celui-ci peut à nouveau être recyclé en réitérant l'invention.

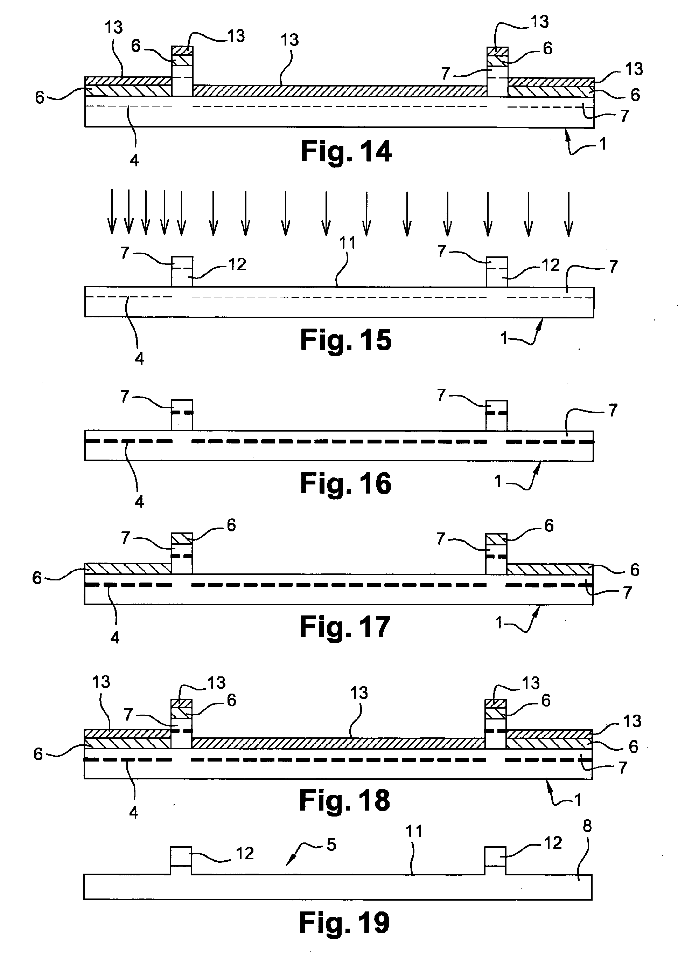

Selon une variante de réalisation illustrée à la figure 14, une couche superficielle 13, par exemple en Si est déposée avec une épaisseur de 5 micromètres sur le film mince 7 et sur l'empilement 6 formé par les couches déposées successivement avant de procéder à l'étape b) d'exfoliation. Cette couche superficielle 13 contribue de par son épaisseur à augmenter la raideur de l'ensemble de matériaux présent au-dessus du plan de fragilisation enterré 4 de sorte que l'exfoliation conduit à la formation de fragments de plus grandes dimensions. Ceci facilite ensuite l'étape de retrait c) et la finalisation du recyclage du négatif 8 du support 1 de substrat.

Selon une autre variante de réalisation, une couche superficielle 13 de dioxyde de silicium est déposée à 200°C par PECVD (Plasma Enhanced Chemical Vapor Deposition) avec une épaisseur de 10 micromètres sur un empilement 6 de couches de TiO₂ d'épaisseur 1 micromètre provenant des dépôts successifs d'une couche 3 sur un substrat 2. Le matériau SiO₂ ne présente pas le même CTE que celui du matériau Si de sorte que lors de l'application du traitement thermique d'exfoliation à 500°C de l'étape b) du procédé, la couche 13 de SiO₂ est soumise à une contrainte en tension contribuant à l'exfoliation. L'exfoliation étant favorisée, la durée du traitement thermique d'exfoliation peut être réduite par comparaison à celle appliquée en absence d'une couche 13 contrainte, tout en permettant l'exfoliation de fragments de grandes dimensions. L'utilisation d'une couche 13 contrainte peut par ailleurs permettre en amont une réduction de la dose d'implantation des ions hydrogène dans le support 1 de silicium. La dose peut en effet être réduite de 5.10¹⁶ at/cm² à 4.10¹⁶ at/cm² de sorte que le temps de cycle est plus court et que le procédé de recyclage est moins coûteux.

Selon encore une autre variante de réalisation, une couche superficielle 13 de silicium amorphe est déposée par PECVD à une température de 250°C sur une épaisseur de 15 micromètres. L'implantation ayant été réalisée au préalable avec une dose de 4.10¹⁶ at/cm², un traitement thermique d'exfoliation à 500°C pendant 1 heure permet l'exfoliation de l'empilement 6.

Les figures 15 à 19 illustrent une autre variante de réalisation du procédé. Comme illustré à la figure 15, une étape a) d'implantation d'ions hélium est effectuée avec une énergie de 190 keV et une dose de 6.10¹⁶ at/cm² sous la face d'accueil 5 d'un support 1 de substrat en silicium.

Puis en référence à la figure 16, un prétraitement thermique est effectué à 900°C pendant 2 heures de sorte à accroitre le nombre et les dimensions des cavités d'hélium au niveau du plan de fragilisation enterré 4, sans pour autant provoquer l'exfoliation du film mince 7 de silicium. Il est entendu dans le présent document que le prétraitement thermique est également adapté à ce que le budget thermique des étapes de dépôts de couche 3 ultérieurs ne provoque pas l'exfoliation.

La figure 17 illustre le support 1 de substrat après utilisation et dépôts successifs d'une couche 3 de TiO₂ sur un substrat 2, jusqu'à atteindre une épaisseur seuil d'empilement 6 d'environ 5 micromètres sur le support 1. Il est à noter que l'empilement 6 de TiO₂ est mis en compression lors du traitement thermique d'exfoliation mais la contrainte générée n'est pas suffisante à elle seule pour obtenir son exfoliation.

La figure 18 illustre une étape de dépôt d'une couche superficielle 13 de nitrure de silicium par PECVD à 400°C jusqu'à atteindre une épaisseur d'environ 10 micromètres. Une fois de retour à température ambiante, la différence de contraction du silicium du support 1 et du nitrure de silicium de la couche superficielle 13, ainsi que les contraintes intrinsèques du dépôt génèrent une contrainte dans le support 1. Compte tenu de l'application d'un prétraitement thermique au préalable, cette contrainte suffit à elle seule pour provoquer l'exfoliation du film mince 7.

Comme illustré à la figure 19, le négatif 8 du support 1 de substrat récupéré après retrait des fragments et nettoyage présente une région principale plane 11 et une région périphérique 12 sous forme d'une couronne de matière, identiques à celles du support 1 de substrat avant utilisation.

Ainsi, la présente invention propose un procédé de recyclage de support 1 de substrat simple à mettre en oeuvre, pouvant être utilisé quelle que soit la nature du matériau et la géométrie du support 1.

Il va de soi que l'invention n'est pas limitée aux variantes de réalisation décrites ci-dessus à titre d'exemples mais qu'elle comprend tous les équivalents techniques et les variantes des moyens décrits ainsi que leurs combinaisons.

## Revendications

1. Procédé de recyclage d'un support (1) de substrat dont une face (5), dite face d'accueil, est adaptée à la réception d'un substrat (2) conçu pour au moins une étape de dépôt d'une couche d'un matériau (3) sur ledit substrat (2), l'étape de dépôt conduisant également au dépôt d'une couche d'un matériau sur ledit support (1) de substrat, le procédé comprenant les étapes consistant à :
a) Implanter des espèces ioniques à travers la face d'accueil (5) du support (1) de substrat de sorte à former au moins un plan de fragilisation enterré (4) délimitant un film mince (7) sous la face d'accueil (5) du support (1) de substrat,
b) Exfolier le film mince (7) du support (1) de substrat de sorte à morceler le film mince (7), et
c) Retirer un empilement (6) comportant au moins la couche d'un matériau déposé sur le film mince (7) résultant de ladite au moins une étape de dépôt de la couche d'un matériau (3) sur le substrat (2).

2. Procédé de recyclage selon la revendication 1, **caractérisé en ce que** le procédé comporte, après l'étape d'implantation a), une étape de formation d'une couche additionnelle (9) sur le film mince (7) du support (1) de substrat et **en ce que** l'étape de retrait c) comporte une étape de pelage de la couche additionnelle (9).

3. Procédé de recyclage selon l'une des revendications 1 à 2, **caractérisé en ce que** la couche additionnelle (9) est réalisée en un matériau de polymère, notamment en polymère vitreux, tel que le BenzoCycloButène (BCB).

4. Procédé de recyclage selon l'une des revendications 1 à 3, **caractérisé en ce que** l'étape de retrait c) comporte une étape de nettoyage de la surface (5) du négatif (8) du support (1) de substrat par jet d'eau sous pression.

5. Procédé de recyclage selon l'une des revendications 1 à 4, **caractérisé en ce que** l'étape d'exfoliation b) du film mince (7) comprend une étape d'application d'un traitement thermique d'exfoliation.

6. Procédé de recyclage selon l'une des revendications 1 à 5, **caractérisé en ce que** l'étape d'implantation a) conduit à la formation de cavités définissant le film mince (7) et **en ce que** le procédé comprend après l'étape d'implantation a) et avant l'étape d'exfoliation b) une étape de prétraitement thermique adaptée à la croissance du nombre et de la taille de cavités.

7. Procédé de recyclage selon l'une des revendications 1 à 6, **caractérisé en ce que** l'étape d'exfoliation b) du film mince (7) comprend une étape comportant un dépôt d'une couche superficielle (13) sur le film mince (7) et sur l'empilement (6) d'au moins la couche d'un matériau déposée sur le film mince (7).

8. Procédé de recyclage selon la revendication 7, **caractérisé en ce que** le matériau de la couche superficielle (13) présente un coefficient de dilatation thermique (CTE) différent du (CTE) du matériau du support (1) de substrat.

9. Procédé de recyclage selon l'une des revendications 1 à 8, **caractérisé en ce que** la face d'accueil (5) du support (1) de substrat comporte une région principale plane (11) permettant de recevoir un substrat (2) et une région périphérique (12) comprenant une surépaisseur de matière permettant de maintenir le substrat (2) pour le dépôt d'une couche d'un matériau (3), et **en ce que** l'étape d'implantation a) comprend une implantation d'espèces ioniques à travers la région périphérique (12) de la face d'accueil (5) de sorte que le plan de fragilisation enterré (4) délimite le film mince (7) sous la région périphérique (12).

10. Procédé de recyclage selon la revendication 9, **caractérisé en ce que** l'étape d'implantation a) est réalisée à travers la région principale plane (11) et à travers la région périphérique (12) de la face d'accueil (5) conduisant à la formation d'un premier plan de fragilisation enterré sous la région principale plane (11) et la formation d'un deuxième plan de fragilisation enterré sous la région périphérique (12), le cumul du premier plan de fragilisation enterré et du deuxième plan de fragilisation enterré délimitant le film mince (7).

11. Procédé de recyclage selon l'une des revendications 1 à 10, **caractérisé en ce que**, avant l'étape d'exfoliation b), le procédé comprend plusieurs étapes successives de dépôt d'une couche (3) d'au moins un matériau de manière à former un empilement (6) de plusieurs couches successives d'au moins un matériau sur le film mince (7).

12. Procédé de recyclage selon l'une des revendications 1 à 11, **caractérisé en ce que** l'étape b) d'exfoliation est réalisée lorsque l'épaisseur de l'empilement (6) d'au moins une couche d'un matériau déposé sur le film mince (7) est de préférence inférieure à 50 micromètres, voire inférieure à 20 micromètres, et par exemple comprise entre 1 et 7 micromètres.

13. Procédé de recyclage selon l'une des revendications 1 à 12, **caractérisé en ce que** le support (1) de substrat comprend une plaque de silicium de 300 mm de diamètre comportant une région périphérique sous forme de couronne (12) présentant une épaisseur supérieure à 725 micromètres et une largeur comprise entre 5 mm et 5 cm, le support (1) de substrat étant adapté pour au moins une manipulation d'un substrat (2) de silicium présentant un diamètre de 200 mm et pour au moins le dépôt d'une couche d'un matériau (3) en dioxyde de titane d'une épaisseur d'environ 1,5 micromètres, l'étape a) comprenant une implantation d'hydrogène avec une énergie comprise entre 1 et 300keV et une dose comprise entre 1.10¹⁵ et 1.10¹⁷ at/cm², l'étape d'exfoliation b) comprenant l'application d'un traitement thermique à une température comprise entre 200°C et 500°C sur une durée comprise entre quelques minutes à quelques heures et l'étape de retrait c) de l'empilement (6) comprenant une étape de formation puis une étape de pelage d'une couche additionnelle (9) en BCB déposée sur le film mince (7).

## Patentansprüche

1. Recyclingverfahren einer Substratunterlage (1), von der eine Seite (5), genannt Aufnahmeseite, ausgelegt ist, um ein Substrat (2) aufzunehmen, das für mindestens einen Schritt des Ablagerns einer Schicht aus einem Material (3) auf dem Substrat (2) entworfen ist, wobei der Schritt des Ablagerns auch zur Ablagerung einer Schicht aus einem Material auf der Substratunterlage (1) führt, wobei das Verfahren die Schritte umfasst, die aus Folgendem bestehen:
a) Implantieren der Ionenarten über die Aufnahmeseite (5) der Substratunterlage (1), um mindestens eine erdverlegte Versprödungsebene (4) zu bilden, die einen dünnen Film (7) unter der Aufnahmefläche (5) der Substratunterlage (1) begrenzt,
b) Abblättern des dünnen Films (7) der Substratunterlage (1), um den dünnen Film (7) zu zerstückeln, und
c) Entfernen eines Stapels (6), der mindestens die Schicht aus einem Material, die auf dem dünnen Film (7) abgelagert ist, umfasst, der sich aus dem mindestens einen Schritt des Ablagerns der Schicht aus einem Material (3) auf dem Substrat (2) ergibt.

2. Recyclingverfahren nach Anspruch 1, **dadurch gekennzeichnet, dass** das Verfahren, nach dem Schritt des Implantierens a), einen Schritt des Bildens einer zusätzlichen Schicht (9) auf dem dünnen Film (7) der Substratunterlage (1) umfasst, und dadurch, dass der Schritt des Entfernens c) einen Schritt des Abschabens der zusätzlichen Schicht (9) umfasst.

3. Recyclingverfahren nach einem der Ansprüche 1 bis 2, **dadurch gekennzeichnet, dass** die zusätzliche Schicht (9) aus einem Polymermaterial hergestellt ist, insbesondere aus glasigem Polymer wie z.B. Benzocyclobuten (BCB).

4. Recyclingverfahren nach einem der Ansprüche 1 bis 3, **dadurch gekennzeichnet, dass** der Schritt des Entfernens c) einen Schritt des Reinigens der Oberfläche (5) des Negativs (8) der Substratunterlage (1) durch einen Wasserstrahl unter Druck umfasst.

5. Recyclingverfahren nach einem der Ansprüche 1 bis 4, **dadurch gekennzeichnet, dass** der Schritt des Abblätterns b) des dünnen Films (7) einen Schritt des Anwendens eines thermischen Abblätterungsverfahrens umfasst.

6. Recyclingverfahren nach einem der Ansprüche 1 bis 5, **dadurch gekennzeichnet, dass** der Schritt des Implantierens a) zur Bildung von Hohlräumen führt, die den dünnen Film (7) definieren, und dadurch, dass das Verfahren nach dem Schritt des Implantierens a) und vor dem Schritt des Abblätterns b) einen Schritt des thermischen Vorbehandelns umfasst, der an die Erhöhung der Anzahl und der Größe der Hohlräume angepasst ist.

7. Recyclingverfahren nach einem der Ansprüche 1 bis 6, **dadurch gekennzeichnet, dass** der Schritt des Abblätterns b) des dünnen Films (7) einen Schritt umfasst, der ein Ablagern einer Oberflächenschicht (13) auf dem dünnen Film (7) und auf dem Stapel (6) von mindestens der Schicht aus einem Material, die auf dem dünnen Film (7) abgelagert ist, umfasst.

8. Recyclingverfahren nach Anspruch 7, **dadurch gekennzeichnet, dass** das Material der Oberflächenschicht (13) einen Wärmeausdehnungskoeffizienten aufweist, der verschieden vom Wärmeausdehnungskoeffizienten des Materials der Substratunterlage (1) ist.

9. Recyclingverfahren nach einem der Ansprüche 1 bis 8, **dadurch gekennzeichnet, dass** die Aufnahmefläche (5) der Substratunterlage (1) einen ebenen Hauptbereich (11) umfasst, der ermöglicht, ein Substrat (2) aufzunehmen, und einen peripheren Bereich (12), der eine Materialverdickung umfasst, der ermöglicht, das Substrat (2) für die Ablage einer Schicht aus einem Material (3) zu halten, und dadurch, dass der Schritt des Implantierens a) ein Implantieren von lonenarten über den peripheren Bereich (12) der Aufnahmeseite (5) umfasst, so dass die erdverlegte Versprödungsebene (4) den dünnen Film (7) unter dem peripheren Bereich (12) begrenzt.

10. Recyclingverfahren nach Anspruch 9, **dadurch gekennzeichnet, dass** der Schritt des Implantierens a) über den ebenen Hauptbereich (11) und über den peripheren Bereich (12) der Aufnahmeseite (5) erfolgt, was zur Bildung einer ersten erdverlegten Versprödungsebene unter dem Hauptbereich (11) und der Bildung einer zweiten erdverlegten Versprödungsebene unter dem peripheren Bereich (12) führt, wobei die Akkumulation der ersten erdverlegten Versprödungsebene und der zweiten erdverlegten Versprödungsebene den dünnen Film (7) begrenzt.

11. Recyclingverfahren nach einem der Ansprüche 1 bis 10, **dadurch gekennzeichnet, dass** vor dem Schritt des Abblätterns b) das Verfahren mehrere aufeinander folgende Schritte des Ablagerns einer Schicht (3) aus mindestens einem Material umfasst, um einen Stapel (6) aus mehreren aufeinander folgenden Schichten aus mindestens einem Material auf dem dünnen Film (7) zu bilden.

12. Recyclingverfahren nach einem der Ansprüche 1 bis 11, **dadurch gekennzeichnet, dass** der Schritt b) des Abblätterns erfolgt, wenn die Dicke des Stapels (6) aus mindestens einer Schicht aus einem Material, die auf dem dünnen Film (7) abgelagert ist, vorzugsweise weniger als 50 Mikrometer beträgt, ja sogar weniger als 20 Mikrometer, und zum Beispiel zwischen 1 und 7 Mikrometer liegt.

13. Recyclingverfahren nach einem der Ansprüche 1 bis 12, **dadurch gekennzeichnet, dass** die Substratunterlage (1) eine Siliziumplatte mit einem Durchmesser von 300 mm umfasst, die einen peripheren Bereich in Form einer Krone (12) aufweist, der eine Dicke von mehr als 725 Mikrometern und eine Breite zwischen 5 mm und 5 cm aufweist, wobei die Substratunterlage (1) für mindestens eine Handhabung eines Siliziumsubstrats (2) mit einem Durchmesser von 200 mm und für mindestens die Ablagerung einer Schicht aus einem Material (3) aus Titandioxid mit einer Dicke von ungefähr 1,5 Mikrometern ausgelegt ist, wobei der Schritt a) ein Implantieren von Wasserstoff mit einer Energie zwischen 1 und 300keV und einer Dosis zwischen 1.10¹⁵ und 1.10¹⁷ at/cm² umfasst, wobei der Schritt des Abblätterns b) das Anwenden einer thermischen Behandlung bei einer Temperatur zwischen 200 °C und 500 °C während einer Dauer zwischen einigen Minuten bis einigen Stunden umfasst, und der Schritt des Entfernens c) des Stapels (6) einen Schritt des Bildens, dann einen Schritt des Abschabens einer zusätzlichen Schicht (9) aus BCB umfasst, die auf dem dünnen Film (7) abgelagert ist.

## Claims

1. A method of recycling a substrate support (1) of which one face (5), called receiving face, is suitable for receiving a substrate (2) designed for at least one step of depositing a layer of a material (3) on said substrate (2), the depositing step also leading to the deposit of a layer of a material on said substrate support (1), the method comprising the steps consisting in:
a) Implanting ionic species through the receiving face (5) of the substrate support (1) in such a manner as to form at least one buried weakened plane (4) delimiting a thin film (7) under the receiving face (5) of the substrate support (1),
b) Exfoliating the thin film (7) of the substrate support (1) in such a manner as to fragment the thin film (7), and
c) Remove a stacking (6) including at least the layer of a material deposited on the thin film (7) resulting from said at least step of depositing the layer of a material (3) on the substrate (2).

2. The recycling method according to claim 1, **characterized in that** the method includes, after the implantation step a), a step of forming an additional layer (9) on the thin film (7) of the substrate support (1) and **in that** the removal step c) includes a step of peeling the additional layer (9).

3. The recycling method according to any of claims 1 to 2, **characterized in that** the additional layer (9) is made in a polymer material, in particular in a vitreous polymer, such as BenzoCycloButene (BCB).

4. The recycling method according to any of claims 1 to 3, **characterized in that** the removal step c) includes a step of cleaning the surface of the negative (8) of the substrate support (1) by pressurized water jet.

5. The recycling method according to any of claims 1 to 4, **characterized in that** the step of exfoliating b) the thin film (7) comprises a step of applying a thermal exfoliation treatment.

6. The recycling method according to any of claims 1 to 5, **characterized in that** the implantation step a) leads to the formation of cavities defining the thin film (7) and **in that** the method comprises after the implantation step a) and before the exfoliation step b) a step of thermal pretreatment suitable for the growth in number and size of the cavities.

7. The recycling method according to any of claims 1 to 6, **characterized in that** the step of exfoliating b) the thin film (7) comprises a step including a deposit of a superficial layer (13) on the thin film (7) and on the stacking (6) of at least the layer of a material deposited on the thin film (7).

8. The recycling method according to claim 7, **characterized in that** the material of the superficial layer (13) has a coefficient of thermal expansion different from the coefficient of thermal expansion (CTE) of the material of the substrate support (1)

9. The recycling method according to any of claims 1 to 8, **characterized in that** the receiving face (5) of the substrate support (1) includes a flat main region (11) allowing to receive a substrate (2) and a peripheral region (12) comprising an overthickness of matter allowing to maintain the substrate (2) for the deposit of a layer of a material (3), and **in that** the implantation step a) comprises an implantation of ionic species through the peripheral region (12) of the receiving face (5) such that the buried weakened plane (4) delimits the thin film (7) below the peripheral region (12).

10. The recycling method according to claim 9, **characterized in that** the implantation step a) is made through the flat main region (11) and through the peripheral region (12) of the receiving face (5) leading to the formation of a first weakened plane buried under the flat main region (11) and the formation of a second weakened plane buried under the peripheral region (12), the accumulation of the first buried weakened plane and the second buried weakened plane delimiting the thin film (7).

11. The recycling method according to any of claims 1 to 10, **characterized in that**, before the exfoliation step b), the method comprises several successive steps of depositing a layer (3) of at least one material in such a manner as to form a stacking (6) of several successive layers of at least one material on the thin film (7).

12. The recycling method according to any of claims 1 to 11, **characterized in that** the exfoliation step b) is made when the thickness of the stacking (6) of at least one layer of a material deposited on the thin film (7) is preferably less than 50 micrometers, or even less than 20 micrometers, and for example between 1 and 7 micrometers.

13. The recycling method according to any of claims 1 to 12, **characterized in that** the substrate support (1) comprises a silicon plate with a diameter of 300 mm including a peripheral region in the form of a ring (12) having a thickness higher than 725 micrometers and a width between 5 mm and 5 cm, the substrate support (1) being suitable for at least one handling of a silicon substrate (2) having a diameter of 200 mm and for at least the deposit of a layer of a material (3) in titanium dioxide of a thickness of around 1.5 micrometers, the step a) comprising an implantation of hydrogen with energy between 1 and 300keV and a dose between 1.10¹⁵ and 1.10¹⁷ at/cm², the exfoliation step b) comprising the application of a thermal treatment at a temperature between 200°C and 500°C over a period between a few minutes to a few hours and the step c) of removing the stacking (6) comprising a formation step then a step of peeling an additional layer (9) in BCB deposited on the thin film (7).
